# EUROPEAN PATENT APPLICATION

(11) **EP 2 728 614 A1**
(43) Date of publication of application: **07.05.2014**
(21) Application number: 12197994.2
(22) Date of filing: 19.12.2012
(51) Int. Cl.: H01L 23/427

(54) **Heated-side contact structure of thin heat pipe**

(30) Priority: 01.11.2012 TW 101221129
(71) Applicant: Chen, Yu-Syuan, New Taipei City 238 (TW)
(72) Inventor: Chen, Yu-Syuan, 238 Shulin Dist., New Taipei City (TW)
(74) Representative: 2K Patentanwälte Blasberg Kewitz & Reichel

(57) **Abstract**

A heated-side contact structure includes a heat pipe (1) having a heated end (10) and a thermally conductive base (2) having two combining elements (20). The heated end (10) of the heat pipe (1) is flat and has a heating side (100), a top side (101) opposite to the heating side (100), and two lateral sides (102) between the heating side (100) and the top side (101) respectively. The heated end (10) is between the two combining elements (20) and each combining element (20) has a bottom (200). The lateral side (102) of the heated end (10) is attached and thermally conducted with an adhering surface (201). The adhering surfaces (201) of the combining elements (20) are combined with the lateral sides (102) of the heated end (10) respectively, and the bottoms (200) of the combining elements (20) and the heating side (100) of the heated end (10) are coplanar.

## Description

### FIELD OF THE INVENTION

The present invention relates to a heat dissipating device, and more particularly to a heated-side contact structure of a thin heat pipe.

### BACKGROUND OF THE INVENTION

At present, many electronic products, particularly the portable electronic products are developed with a thin, light, short and compact design, and thus the thin, light, short and compact features must be taken into consideration for a heat sink installed in the internal space of the electronic products, and the thin design of a heat pipe is one of the solutions for achieving the aforementioned effect.

However, a general thin heat pipe is manufactured by pressing a circular tubular heat pipe into a flat heat pipe, and then using a metal fixing plate to attach the flat heat pipe onto a surface of an electronic heat-generating component and fix onto a printed circuit board, so that it is difficult to achieve the required small thickness due to the thickness of the metal fixing plate.

In view of the aforementioned problem, the inventor of the present invention based on years of experience in the related industry to conduct extensive researches and experiments to develop and design a heated-side contact structure of a thin heat pipe to overcome the aforementioned problem.

### SUMMARY OF THE INVENTION

Therefore, it is a primary objective of the present invention to provide a heated-side contact structure of a thin heat pipe, and the heated-side contact structure has a thickness not exceeding the thickness of the heat pipe, or a thickness exceeding but approximately equal to the thickness of the heat pipe, so as to provide a sufficient fixing force for the heated end of the heat pipe and a sufficient contact area for the contact with an electronic heat-generating component. In other words, when the heated end of the heat pipe is attached onto the electronic heat-generating component, the total height is at most equal to the thickness of the heated end of the heat pipe in order to meet the required thickness requirement.

To achieve the aforementioned objective, the present invention provides a heated-side contact structure of a thin heat pipe, and the structure comprises a heat pipe having a heated end and a thermally conductive base including two combining elements, wherein the heated end of the heat pipe is substantially flat and has a heating side, a top side opposite to the heating side, and two lateral sides disposed on two sides between the heating side and the top side respectively, and the heated end is disposed between the two combining elements, and each combining element has a bottom, and an adhering surface adhered with the lateral side of the heated end for thermal conduction, and the adhering surfaces of the two combining elements are combined with the two lateral sides of the heated end respectively, and the bottoms of the two combining elements and the heating side of the heated end are coplanar.

### BRIEF DESCRIPTION OF THE DRAWINGS

FIG. 1 is a perspective view of a heat sink module of the present invention;

FIG. 2 is an exploded view of a first preferred embodiment of the present invention;

FIG. 3 is a schematic view of a combining movement of the first preferred embodiment of the present invention;

FIG. 4 is a cross-sectional view of the first preferred embodiment of the present invention;

FIG. 5 is a perspective view of the first preferred embodiment of the present invention;

FIG. 6 is a cross-sectional view of a second preferred embodiment of the present invention;

FIG. 7 is a cross-sectional view of a third preferred embodiment of the present invention;

FIG. 8 is a cross-sectional view of a fourth preferred embodiment of the present invention;

FIG. 9 is a perspective view of a fifth preferred embodiment of the present invention;

FIG. 10 is a cross-sectional view of the fifth preferred embodiment of the present invention;

FIG. 11 is a cross-sectional view of the fifth preferred embodiment of the present invention applied to an electronic heat-generating component; and

FIG. 12 is a cross-sectional view of the sixth preferred embodiment of the present invention.

### DESCRIPTION OF THE PREFERRED EMBODIMENTS

The technical contents of the present invention will become apparent with the detailed description of preferred embodiments accompanied with the illustration of related drawings as follows.

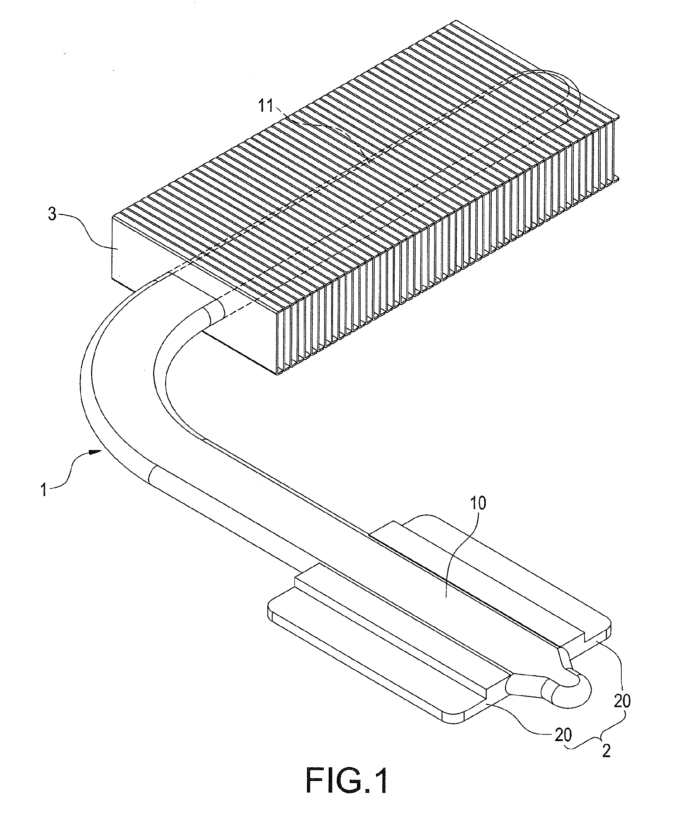

With reference to FIG. 1 for a perspective view of a heat sink module of the present invention, the present invention provides a heated-side contact structure of a thin heat pipe comprising a heat pipe 1, a thermally conductive base 2 installed at an end of the heat pipe 1, and a plurality of heat sink 3 installed at the other end of the heat pipe 1.

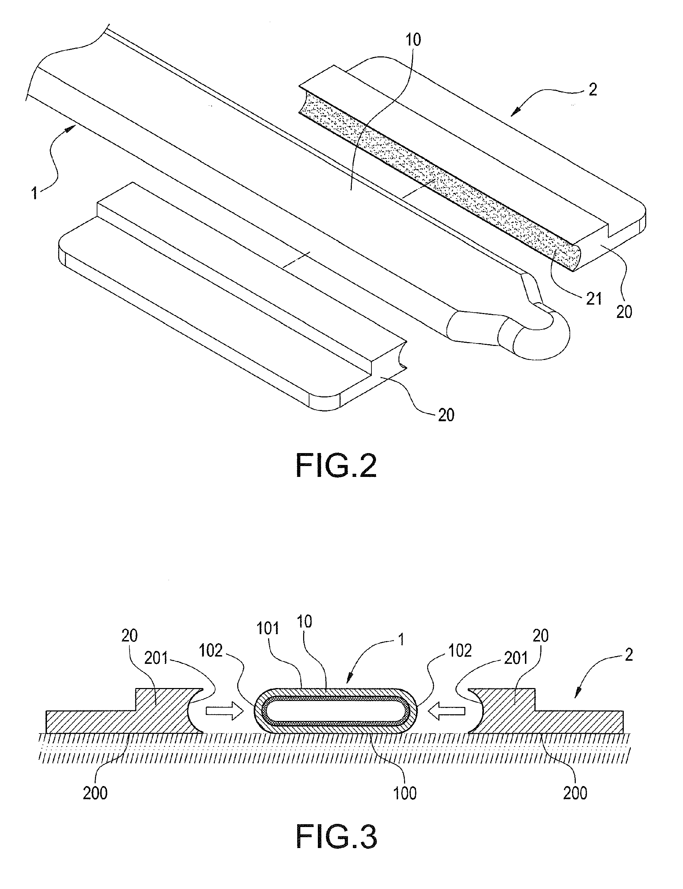

With reference to FIGS. 2 and 3, an end of the heat pipe 1 is a heated end 10, and the heated end 10 is substantially flat and has a heating side 100 on the bottom, a top side 101 opposite to the heating side 100 and two lateral sides 102 disposed on both sides of between the heating side 100 and the top side 101 respectively, and the heating side 100 is provided for a direct contact with an electronic heat-generating component such as a CPU (not shown in the figure), and the thermally conductive base 2 is combined with the two lateral sides 102 of the heated end 10, and the thermally conductive base 2 and the heating side 100 of the heated end 10 are jointly attached onto the surfaces of the electronic heat-generating component to constitute the heated-side contact structure of the present invention. In addition, the other end of the heat pipe 1 is a condensing end 11, and each heat sink 3 is provided for a cooling effect to dissipate the heat generated by the electronic heat-generating component.

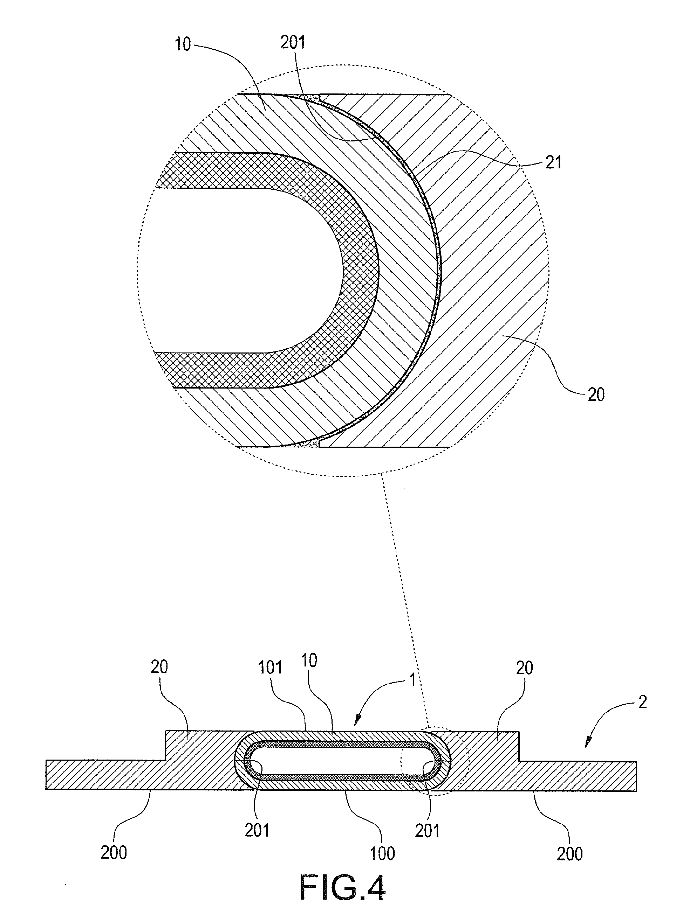

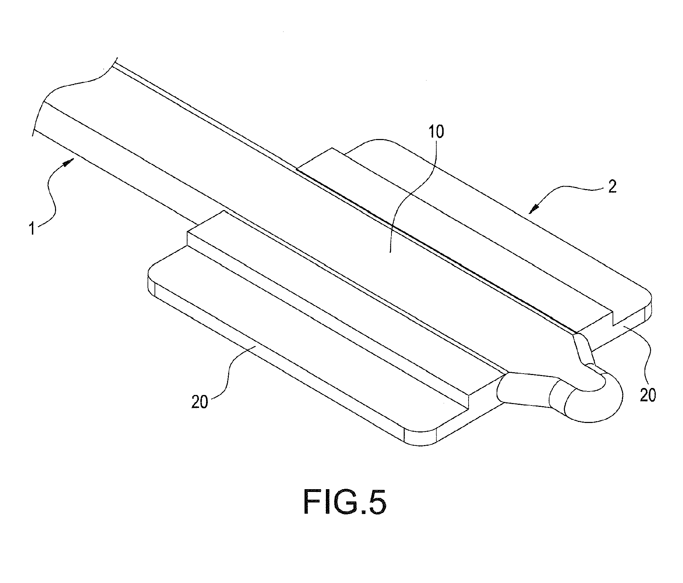

In FIGS. 2 to 5, the thermally conductive base 2 includes two combining elements 20, and the heated end 10 of the heat pipe 1 is disposed between the two combining elements 20, and the thickness of the two combining elements 20 is preferably smaller than or equal to the thickness of the heated end 10 of the heat pipe 1, and it is necessary to include the range of possible errors and tolerances for structural design or mechanical manufacture, so that the thickness of the two combining elements 20 is slightly greater than the thickness of the heated end 10 of the heat pipe 1, and the two combining elements 20 are symmetrical and combined with the two lateral sides 102 of the heated end 10 of the heat pipe 1 respectively. Each combining element 20 has a bottom 200 and an adhering surface 201 corresponding to the lateral side 102, and the adhering surface 201 and the lateral side 102 are combined through a thermally conductive adhesion which can be soldering, welding, gluing or applying a thermally conductive medium 21 (as indicated by the enlarged section in FIG. 4) between the adhering surface 201 and the lateral side 102, wherein the thermally conductive medium 21 can be a tin solder or a thermal conductive adhesive, and the bottoms 200 of the two combining elements 20 and the heating side 100 of the heated end 10 are coplanar. The term "coplanar" includes the range of errors and tolerances of structural design or mechanical manufacture or possible errors and tolerances. In this preferred embodiment, the two combining elements 20 are plates with a concave cambered surface at the position of the adhering surface 201, and the lateral side 102 of the heat pipe 1 is a convex cambered surface.

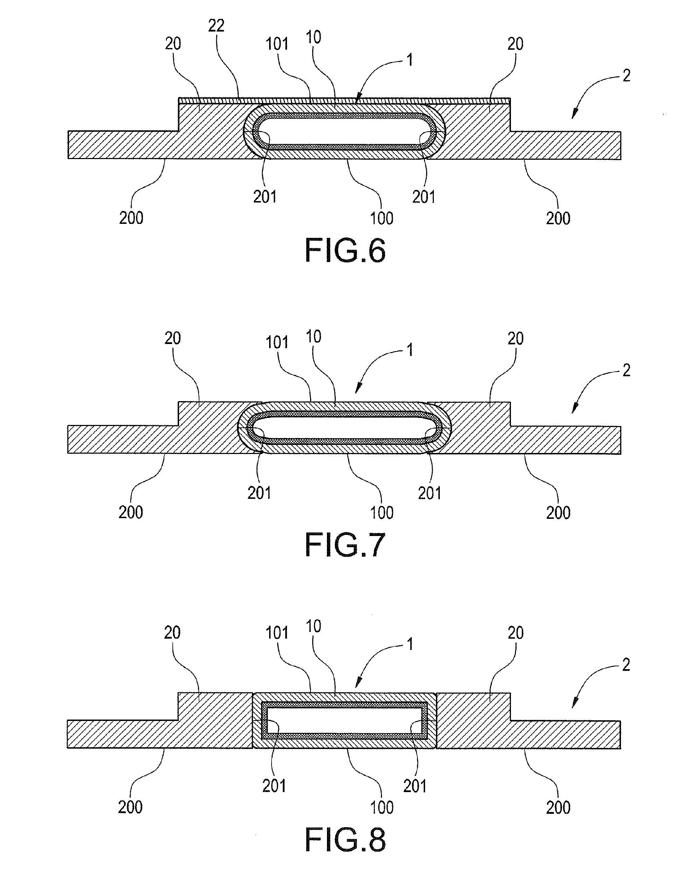

With reference to FIG. 6 for a cross-sectional view of the second preferred embodiment of the present invention, this preferred embodiment bases on the first preferred embodiment and further comprises a thin metal plate 22 with a thickness preferably below 0.5mm, and the thin metal plate 22 is attached onto the two combining elements 20 and the top of the top side 101 of the heated end 10 by soldering, welding or gluing for reinforcing the fixation of the thermally conductive base 2.

With reference to FIG. 7 for a cross-sectional view of the third preferred embodiment of the present invention, the two combining elements 20 at the adhering surface 201 have a thickness slightly smaller than the thickness of the heated end 10 of the heat pipe 1, and the a tool is used to compress the two lateral sides 102 of the heated end 10 of the heat pipe 1 into the adhering surface 201 by a packing method, so as to increase the combining effect by the compression. In FIG. 8, the two combining elements 20 at the adhering surface 201 have flat surfaces, and the lateral side 102 of the heat pipe 1 is also a flat surface.

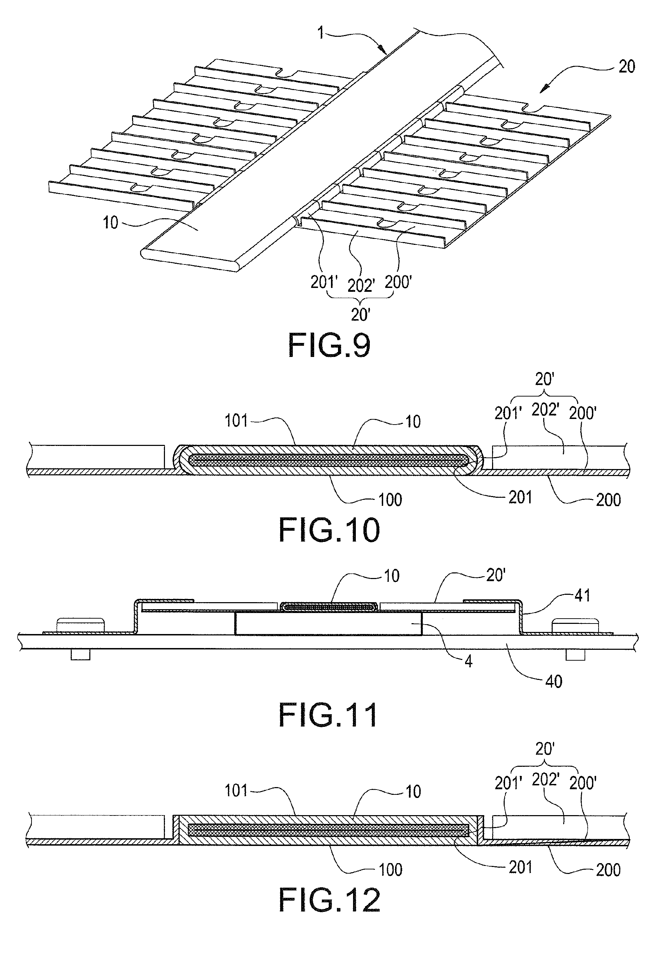

With reference to FIGS. 9 and 10 for the fifth preferred embodiment of the present invention, the two combining elements 20 are formed by stacking a plurality of fins 20', and each fin 20' has a base portion 200', a side portion 201' formed at an edge of the base portion 200', and a fin portion 202' bent and formed at the base portion 200', and the bottom 200 is disposed below the base portion 200', and the adhering surface 201 is disposed above side portion 201', and the side portion 201' of each fin 20' is thermally conducted and attached with the lateral side 102 of the heat pipe 1. In FIG. 11, when the heated end 10 of the heat pipe 1 is in a contact with the electronic heat-generating component 4, a bracket 41 can be used for pressing each fin 20' onto the printed circuit board 40 to keep the heated end 10 to be contacted tightly with the electronic heat-generating component 4. In FIG. 12, the two combining elements 20 are formed by stacking a plurality of fins 20' in this preferred embodiment, the side portion 201' at the adhering surface 201 has a flat surface, and the lateral side 102 of the heat pipe 1 also has a flat surface.

In summary there is disclosed a heated-side contact structure including a heat pipe 1 having a heated end 10 and a thermally conductive base 2 having two combining elements 20 . The heated end 10 of the heat pipe 1 is flat and has a heating side 100 , a top side 101 opposite to the heating side 100 , and two lateral sides 102 between the heating side 100 and the top side 101 respectively. The heated end 10 is between the two combining elements 20 and each combining element 20 has a bottom 200 . The lateral side 102 of the heated end 10 is attached and thermally conducted with an adhering surface 201 . The adhering surfaces 201 of the combining elements 20 are combined with the lateral sides 102 of the heated end 10 respectively, and the bottoms 200 of the combining elements 20 and the heating side 100 of the heated end 10 are coplanar.

With the aforementioned structure, the heated-side contact structure of a thin heat pipe in accordance with the present invention is achieved.

## Claims

1. A heated-side contact structure of a thin heat pipe, comprising:
a heat pipe (1), having a flat heated end (10) with a heating side (100), a top side (101) opposite to the heating side (100), and two lateral sides (102) disposed on two sides between the heating side (100) and the top side (101) respectively; and
a thermally conductive base (2), including two combining elements (20), and the heated end (10) being disposed between the two combining elements (20), and each of the combining elements (20) having a bottom (200), and an adhering surface (201) being adhered and thermally conducted with the lateral side (102), and the adhering surfaces (201) of the two combining elements (20) being combined with the two lateral sides (102) of the heated end (100) respectively, and the bottoms (200) of the two combining elements (20) and the heating side (100) of the heated end (10) being coplanar.

2. The heated-side contact structure of a thin heat pipe according to claim 1, wherein the two combining elements (20) are symmetric plates.

3. The heated-side contact structure of a thin heat pipe according to claim 1 or 2, wherein the two combining elements (20) are formed by stacking a plurality of fins (20'), and each of the fins (20') has a base portion (200'), a side portion (201') formed at an edge of the base portion (200'), and a fin portion (202') formed and bent at the base portion (200'), and the bottom (200) is disposed under the base portion (200'), and the adhering surface (201) is disposed above the side portion (201').

4. The heated-side contact structure of a thin heat pipe according to one of the preceding claims, wherein the two combining elements (20) at the adhering surface (201) are concave cambered surfaces and the lateral side (101) of the heat pipe (1) is a convex cambered surface.

5. The heated-side contact structure of a thin heat pipe according to one of the preceding claims, wherein the two combining elements (20) at the adhering surface (201) are flat surfaces and the lateral side (101) of the heat pipe (1) is also a flat surface.

6. The heated-side contact structure of a thin heat pipe according to claim 5, wherein the two combining elements (20) have a thickness substantially not exceeding the thickness of the heated end (10).

7. The heated-side contact structure of a thin heat pipe according to claim 5 or 6, wherein the adhesion for thermal conduction is achieved by soldering, welding, gluing or packing.

8. The heated-side contact structure of a thin heat pipe according to one of the claims 5 to 7, further comprising a thermally conductive medium (21) disposed between the adhering surface (201) and the lateral side (101) for the thermal conduction and adhesion.

9. The heated-side contact structure of a thin heat pipe according to claims 8, wherein the thermally conductive medium (21) is a tin solder or a thermal conductive adhesive.

10. The heated-side contact structure of a thin heat pipe according to one of the preceding claims, further comprising a thin metal plate (22) attached onto the two combining elements (20) and the top of the top side (101) of the heated end (10), and the thin metal plate (22) has a thickness below 0.5mm.
